(19) Europäisches Patentamt
European Patent Office
Office européen des brevets

(11) Publication number: 0 315 152
A2

# (12) EUROPEAN PATENT APPLICATION

(21) Application number: 88118262.0

(51) Int. Cl.4: G03F 7/26

(22) Date of filing: 02.11.88

(30) Priority: 03.11.87 IT 2249387

(43) Date of publication of application:
10.05.89 Bulletin 89/19

(84) Designated Contracting States:
BE DE FR GB NL SE

(71) Applicant: AUSIMONT S.r.l.
31, Foro Buonaparte
I-20121 Milano(IT)

(72) Inventor: Occhiello, Ernesto
13, Corso Cavallotti
I-28100 Novara(IT)
Inventor: Re, Alberto
18, via Castel Morrone
I-20129 Milan(IT)
Inventor: Malatesta, Vincenzo
21, Via Repubblica
I-20093 Cologno Monzese Milan(IT)
Inventor: Garbassi, Fabio
6, Via C.Porta
I-28100 Novarà(IT)

(74) Representative: Barz, Peter, Dr. et al
Patentanwälte Dr. V. Schmied-Kowarzik
Dipl.-Ing. G. Dannenberg Dr. P. Weinhold Dr.
D. Gudel Dipl.-Ing. S. Schubert Dr. P. Barz
Siegfriedstrasse 8
D-8000 München 40(DE)

## (54) Photoablation process for films based on polymers having a perfluoroalkylpolyether structure by means of excimer laser rays.

(57) A photoablation process for coating films based on polymers having a perfluoroalkylpolyether structure by means of excimer laser rays having a wave length ranging from 154 to 350 nm.

EP 0 315 152 A2

# PHOTOABLATION PROCESS FOR FILMS BASED ON POLYMERS HAVING A PERFLUOROALKYL-POLYETHER STRUCTURE BY MEANS OF EXCIMER LASER RAYS

This invention relates to a photoablation process by means of excimer laser rays having a wave length ranging from 153 to 350 nm, for surface coatings based on a polymeric material having a perfluoroalkylpolyether structure.

More particular, the invention relates to the localized photoablation of coatings based on polymers obtained starting from perfluoropolyethers having, at their ends, functional groups susceptible of polycondensation or polyaddition reactions.

Processes for removing polymeric coatings from coated surfaces, such as for examples the one based on mechanical treatments (sandblasting, scraping, etc.), on thermal treatment (flame) and on chemical treatments (washings and baths with corrosive liquids), are known in the art.

The drawback of these processes is that they can be efficaciously utilized only when the surfaces to be treated are broad and in particular when it is not necessary to operate with an accurate precision degree, as is required in a few applications on the field of electronics.

For example, in the field of the printed circuits, the supporting plates are coated with insulating films based on suitable polymers, with the exception of well-defined areas, inside of which the electric contacts are to be carried out.

To obtain this type of product, the most commonly used method is the so-called "masking". According to this method, the microareas of the supporting plates for printed circuits, through which plates the electric contacts are to be realized, are protected, prior to the coating step, by means of suitable adhesive protections. On conclusion of the coating step, the protections are removed and the finished product is ready for the uses it is meant for.

The masking method too is affected by drawbacks: for example it is complicated (and therefore expensive) and it can pollute the support.

As an alternative to the masking method, methods utilizing for example infrared ray lasers have been proposed, such methods having the drawback of providing non well-defined geometries, due to thermal effects, and to sensibly heat the substrate. The Applicant has now found - and this is the object of the present invention - that the above-mentioned drawbacks can be avoided when using a process for the photoablation of surface coatings based on a polymeric material having a perfluoroalkylpolyether structure, the process comprising the irradiation of the coated surface with (focused or non-focused) excimer laser ray bundles, having a wave length ranging from 154 to 350 nm.

Furthermore the Applicant has observed that the coatings based on perfluoroalkylpolyethers are quite resistant to irradiation by means of infrared ray lasers and do not form any carbon residues.

The photoablation process according to the present invention can be profitably utilized when the abovesaid polymeric material has been used as positive photoresist, because it is suited to this use thanks to its resistance to low power UV-radiations, with the exception of the perfluoropolyether polymers having residual acrylic groups. In this case it is possible to sue,at any rate, the corresponding addition polymers. The laser treatment constitutes, in such case, the final ablation of the coating material based on perfluoropoly ether polymers.

According to the process forming the object of the present invention it is possible to obtain, on a surface which is thoroughly coated with a thin polymeric material layer, microareas even smaller than one square micron and with spatially well-defined geometries of the photoablated parts.

In particular, when using the perfluoropolyethers in the process of the present invention, no carbonaceous residues are noticed, which, as is well known, adversely affect the applications indicated in the invention. In this connection, reference should be made in particular to figure 1 (enlargement by 44 times, optical microscope) annexed hereto and concerning the perfluoropolyethers of the invention. Figure 2 ( enlargement by 13 times, optical microscope) shows the result obtained by using polystyrene as a polymer: in this case the carboneceous residues are clearly seen.

The process of the present invention is utilizable for any types of fluorinated polymeric coatings, however the most suitable coatings are those consisting of a polymeric material essentially having a perfluoropolyether structure in the form of a cross-linked or not cross-linked polymer, having such a viscosity as to secure a resistance to removal and to flowing which is adequate to the application of the article. Materials suitable for forming the coating layer are in particular the polymeric materials obtained by polycondensation or polyaddition starting from perfluoropolyethers having functional groups capable of forming polymers.

Suitable starting perfluoropolyethers are the ones consisting of repeating perfluorooxyalkylene units of the following types :

I) $(CF_2CF_2O)$, $(CF_2O)$, said units being statistically distributed along the perfluoroalkylpolyether chain;

II)

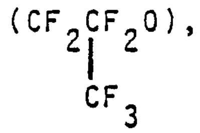

(CFXO) where X = F or $CF_3$,
said units being statistically distributed along the perfluoropolyether chain;

III) $(CF_2CF_2O)$,

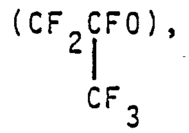

(CFXO) wherein X = F or $CF_3$,
said units being statistically distributed along the perfluoropolyether chain;

IV) 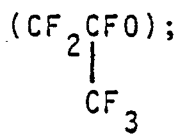

V) $(CH_2CF_2CF_2O)$;

VI) $(CF_2CF_2CF_2O)$;

VII) $(O\text{-}CF_2\text{-}CF_2\text{-}CH_2)_p\text{-}(R'_f)_n\text{-}O\text{-}(CH_2\text{-}CF_2\text{-}CF_2\text{-}O)_q$

wherein $R'_f$ is a fluoroalkylene group, n is O or 1, p and q are integers and p+q is 1-200;

VIII) 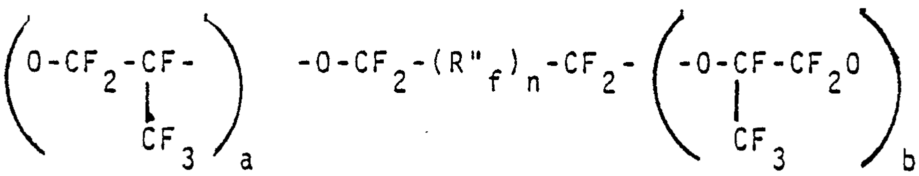

IX) $(CF_2CF_2O)$.

The starting perfluoropolyethers of classes III, VI and IX can be functionalized, if necessary, at both ends by utilizing for example the separation process described in Italian patent application No. 22920 A/85, such process giving rise to acid end groups -COF, which are readily convertible to suitable functional end groups.

Functionalized perfluoropolyethers suitable for preparing the coating polymers according to the present invention are the ones described for example in US patent No, 3,810,874.

Polymers having a perfluoroalkylpolyether structure, which are suited to the process of the present invention are, for example :

- polyurethanes,
- epoxy resins,
- polyacrylates,
- polyamides,
- polyimides.

The abovesaid products are described in particular in: Italian patent No. 903,446, Italian patent application No, 19,497 A/85, US patent No. 3,814,741.

It is possible to use also perfluoropolyethers as such, provided they have a sufficiently high molecular weight and possess functional groups which secure a good adhesion of same to the substrate.

The functional groups in question are for example the ones described in European patent publications Nos. 165,649 and 165,650.

The coating layer on the substrate can be obtained by means of a suitable known method: for example it is possible to applicate starting, non-cross-linked polymeric material (pre-polymer) and subsequently to evaporate the solvent and, optionally, to subject the resulting layer to cross-linking treatments according to known techniques (for example thermal or UV irradiation, moisutre curing and the like ). In this connection, patent applications Nos. 22,669 A/85, 19,629 A/85 and 20,871 A/87 can be cited.

The thickness of the film to be removed by means of the laser ray process according to the invention is not critical: however, for the practical applications, films having thicknesses below 100 µm will be generally used.

Any excimer laser apparatus can be utilized for the photoablation of surface coatings based on the polymeric material, provided it emits beams having a wave length ranging from 154 to 350 nm.

As an example let is cite the excimer laser apparatus manufactured by Lambda Physik, model EMG 102, which emits beams at wave lengths of 154 nm, 193 nm, 248 nm, 308 nm, 337 nm, 350 nm.

The impulse duration of the focused excimet laser ray beams utilized for carrying into practice the photoablation process object of the present invention is generally of 15 ns and the repetition frequency ranges from 1 to 100 Hz.

The energy imparted by impulse to the material is lower than 100 mJ (average power at 1 Hz = 100 mW) and the peak power is lower than 10 Watt.

However, it is possible to operate at by far higher frequencies and powers; for example excimer lasers with average powers of 100 W are already available.

The operative modalities for carrying into practice the process object of the present invention are the ones known for the use of laser-beam apparatuses.

It is possible to operate in normal atmosphere environments as well as in controlled atmosphere environments or under vacuum. Depending on the power of the laser, it may be advisable to place the same in the focal plane of a lens which has the function of concentrating and focusing the laser beam, or to utilize a template having the profile to be engraved into the material.

Other optical systems which are utilizable for carrying into practice the process object of the present invention are mirrors and beam splitters, having the purpose of deviating and/or splitting the laser beam into a plurality of secondary beams and optionally of directing them to several points of the sample, diaphragms for the geometry of the area to be photoablated, etc.

A few illustrative but not limitative examples are given hereinafter in order to facilitate the understanding of the present invention and the practical application thereof.

## Example 1

An aluminium plate (5 x 10 cm) coated with a 10 µm thick layer of a perfluoropolyether polyurethane prepared as is described in example 1 of European patent application No. 220, 740, was subjected to photoablation in order to remove the coating in a 1 x 1.5 mm rectangular area.

An excimer laser apparatus manufactured by Lambda Physik, model EMG 102, was utilized.

The laser beam had a wave length of 248 nm, was emitted with an impulse time of 15 ns, the energy delivered for each impulse was equal to 45 mJ, the peak power being equal to 3 MW. The ray was focused in the desired shape and dimensions by means of a spherical lens. The fluency, considered as energy amount irradiated per surface unit, was of 3 J/cm$^2$.

The material was photoablated after application of a single irradiation impulse, at a velocity corresponding to 10 µm/impulse. Through optical microscopy, scanning electron microscopy, X-ray photoelectron spectroscopy and conductivity measurements it was possible to ascertain a complete removal of the polymeric film from the examined area without any subs tantial alteration of the areas surrounding the photoablated area.

The photoablated material is shown in figure 1 (optical microscope (44 X enlargement).

## Example 2

An aluminium plate (5 x 10 cm) coated with a 10µm thick layer of perfluoropolyether-polyurethane

prepared according to example 1 of patent application No. 23184 A/85, was subjected to photoablation in order to effect a linear engraving in the coating having sizes of 0.5 x 20 mm.

An excimer laser apparatus manufactured by Lamba Physik, model EMG 102, was utilized.

The laser beam had a wave length of 350 nm, was emitted with an impulse time of 15 ns, the energy delivered per impulse was equal to 33 mJ, the peak power was at 2.2 MW. The fluency, considered as energy amount irradiated per surface unit, was equal to 0.33 $J/cm^2$.

The material underwent photoablation after application of a single irradiation impulse, at a velocity corresponding to 10 μm/impulse. Through optical microscopy, scanning electron microscopy and conductivity measurements it was possible to ascertain a complete removal of the polymeric film from the examined area without any substantial alteration of the areas surrounding the photoablated area.

Example 3

A silicon plate was coated by using a solution of an acrylated perfluoropolyether monomer,prepared according to example 1 of European patent application No. 193,370, in admixture with a diacrylic monomer of example 2 of said patent, in an acrylate/diacrylate molar ratio of 2:1. The solution in $CF_2Cl-CFCl_2$ was at 1% by weight of total monomers and contained benzophenone, in an amount equal to 0.5% by weight referred to the monomers, as a photo-starter. After evaporation of the solvent, a polymerization and cross-linking treatment by irradiation with UV-rays was carried out. A 10 μm thick coating layer was so obtained.

The plate so coated was subjected to the photoablation process conducted as is described in the preceding example 2.

Through optical microscopy, scanning electron microscopy and conductivity measurements it was possible to ascertain the complete removal of the polymeric film from the treated area without any substantial alteration of the areas surrounding the photoablated area.

**Claims**

1. A photoablation process for surface coatins based on a polymeric material having a perfluoroalkylpolyether structure, which comprises irradiating the surface by means of localized excimer laser beams having a wave length ranging from 154 to 350 nm.

The process of claim 1, wherein the coating polymeric material is prepared starting from perfluoroalkylpolyethers having functional groups susceptible of polyaddition or polycondensation reactions.

3. The process of claim 1, wherein the coating polymeric material consists of a high molecular weight perfluoroalkylpolyether having functional groups, which secure a good adhesion thereof to the substrate.

4. The process of claim 2, wherein the coating polymeric material consists of perfluoropolyether-polyurethane.

T.3712

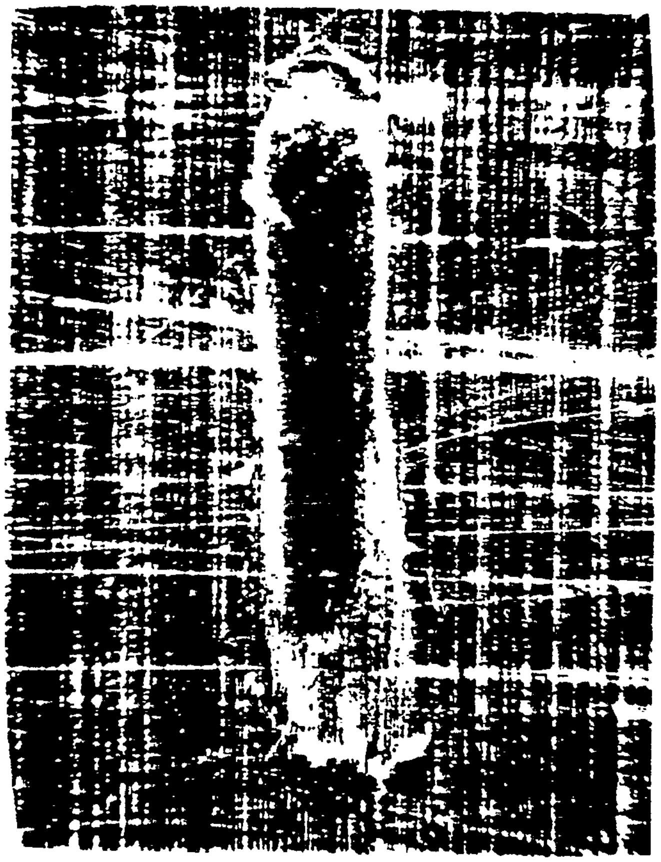

FIG. 1

T.3712

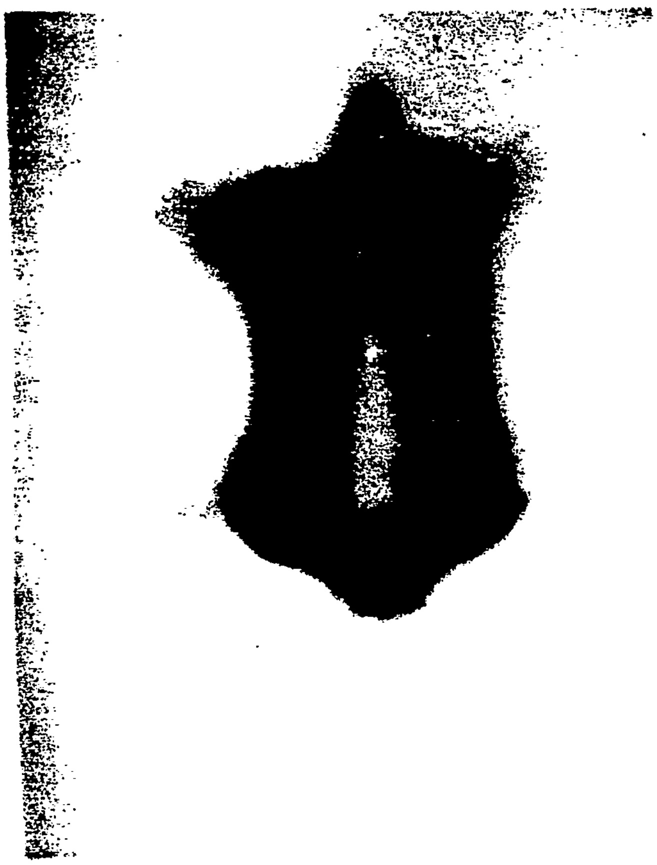

FIG. 2